# EUROPEAN PATENT APPLICATION

(11) **EP 4 482 278 A2**
(43) Date of publication of application: **25.12.2024**
(21) Application number: 24166618.9
(22) Date of filing: 27.03.2024
(51) Int. Cl.: H10K 59/12, H10K 77/10

(54) **DISPLAY DEVICE AND AUTOMOBILE INCLUDING THE SAME**

(30) Priority: 21.06.2023 KR 20230079500
(71) Applicant: Samsung Display Co., Ltd., Yongin-si, Gyeonggi-do 17113 (KR)
(72) Inventor: Lee, Seung Min, 17113 Giheung-gu, Yongin-si, Gyeonggi-do (KR); Kim, Dong Jo, 17113 Giheung-gu, Yongin-si, Gyeonggi-do (KR); Choi, Dan Bi, 17113 Giheung-gu, Yongin-si, Gyeonggi-do (KR)
(74) Representative: Dr. Weitzel & Partner

(57) **Abstract**

A display device includes: a first substrate comprising a first surface and a second surface facing each other and having a rigid material; a second substrate on the first surface of the first substrate and having a flexible material; and an emission material layer on the second substrate and comprising a plurality of light-emitting elements, wherein the first substrate further comprises: an opening exposing the second substrate; a first side surface at an edge adjacent to the opening and between the first surface and the second surface; and a first inclined surface between the first surface and the first side surface, wherein the display device further comprises: a first high-curvature area overlapping the opening; and a first low-curvature area and a second low-curvature area on one side and an opposite side of the first high-curvature area, respectively, and wherein the first high-curvature area overlaps with the emission material layer.

## Description

### BACKGROUND

### 1. Field

Aspects of some embodiments of the present invention relate to a display device and an automobile including the same.

### 2. Description of the Related Art

As the information-oriented society evolves, consumer demand for display devices is ever increasing. Display devices may be flat panel display devices such as a liquid-crystal display device, a field emission display device, and a light-emitting display device.

Display devices find a variety of applications in real life, such as portable electronic devices, in-vehicle displays, and electronic display boards. Such display devices may have a variety of shapes depending on the shape of devices employing them. A flexible display device having a variable shape, such as a bendable, foldable or stretchable display device, may be used. A flexible display device can achieve a relatively high-curvature shape based on high flexibility.

Incidentally, demand for an integrated display is increasing in order to improve process efficiency. For example, for in-vehicle displays, it may be desirable to implement an integrated display used for a dashboard across a driver's seat, a front passenger's seat and a center fascia. In addition, demand for integrated displays is increasing in a variety of applications such as integration of various displays included in portable electronic devices.

As displays are integrated, the size of such displays may become relatively larger. Several efforts are currently under way to improve the surface quality of large-sized flexible display devices. As used herein, the surface quality refers to the flatness of a surface.

The above information disclosed in this Background section is only for enhancement of understanding of the background and therefore the information discussed in this Background section does not necessarily constitute prior art.

### SUMMARY

Aspects of some embodiments of the present invention include a display device that has relatively improved aesthetic appeal and may provide a relatively more compelling user experience by achieving a high-curvature shape, and an automobile including the same.

Aspects of some embodiments of the present invention may include a display device that has relatively improved surface quality, and an automobile including the same.

It should be noted that characteristics of embodiments according to the present invention are not limited to the above-mentioned characteristics; and other characteristics of embodiments according to the present invention will be more apparent to those skilled in the art from the following descriptions.

The Invention is defined by the independent claims.

According to a fist aspect the invention, a display device includes, a first substrate including a first surface and a second surface facing each other and having a rigid material, a second substrate on the first surface of the first substrate and having a flexible material, and an emission material layer on the second substrate and including a plurality of light-emitting elements, wherein the first substrate further includes, an opening exposing the second substrate, a first side surface located at an edge adjacent to the opening and located between the first surface and the second surface, and a first inclined surface located between the first surface and the first side surface, wherein the display device further includes, a first high-curvature area overlapping the opening, and a first low-curvature area and a second low-curvature area located on one side and an opposite side of the first high-curvature area, respectively, and wherein the first high-curvature area overlaps with the emission material layer.

According to some embodiments, the first substrate is not in the first high-curvature area.

According to some embodiments, the display device may further comprise, an undercut between the first inclined surface of the first substrate and the second substrate.

According to some embodiments, a length of the undercut in a horizontal direction is equal to or less than 120 µm.

According to some embodiments, a maximum curvature of the first high-curvature area is greater than maximum curvatures of the first low-curvature area and the second low-curvature area.

According to some embodiments, a minimum radius of curvature of the first high-curvature area is equal to or less than 10 mm.

According to some embodiments, an angle between the first inclined surface and the first surface is less than 15 degrees.

According to some embodiments, an angle between the first side surface and the second surface is less than 60 degrees.

According to some embodiments, the display device may further comprise, a support film in the opening.

According to some embodiments, the support film comprises at least one of, a polyurethane resin, a polyimide resin, a polyethylene resin, or a polypropylene resin.

According to some embodiments, the support film overlaps with the first high-curvature area.

According to some embodiments, the support film is in an undercut between the first inclined surface and the second substrate.

According to some embodiments, a surface of the support film is positioned on a same plane as the second surface of the first substrate.

According to some embodiments, the support film is on the second surface of the first substrate.

According to some embodiments, a minimum radius of curvature of the first high-curvature area is equal to or less than 5 mm.

According to some embodiments, the first substrate is configured to be bent at the first high-curvature area.

According to some embodiments, the first high-curvature area overlaps with a display area in which light emitted by the emission material layer exit.

According to some embodiments, the first substrate comprises glass, and the second substrate comprises a polymer resin.

According to a second aspect of the invention, a display device includes, a first substrate including a first surface, a second surface opposite to the first surface, and a first side surface between the first surface and the second surface, and having a rigid material, a protective layer on the first surface of the first substrate, a second substrate on the protective layer and having a flexible material, and an emission material layer on the second substrate and including a plurality of light-emitting elements, wherein the first substrate further includes an opening exposing the protective layer, wherein the first side surface is positioned at an edge adjacent to the opening, wherein the display device further includes, a first high-curvature area overlapping the opening, and a first low-curvature area and a second low-curvature area located on one side and an opposite side of the first high-curvature area, respectively, and wherein the first high-curvature area overlaps with the emission material layer.

According to some embodiments, the first side surface is connected directly to the first surface.

According to some embodiments, the first substrate is not in the first high-curvature area.

According to some embodiments, a minimum radius of curvature of the first high-curvature area is equal to or less than 10 mm.

According to some embodiments, the display device may further comprise, a support film in the opening.

According to some embodiments, the support film comprises at least one of, a polyurethane resin, a polyimide resin, a polyethylene resin, or a polypropylene resin.

According to some embodiments, the first substrate comprises glass, and the second substrate comprises a polymer resin.

According to y third aspect the invention, an automobile includes, a first dashboard, a second dashboard on one side of the first dashboard, and a display device on the first dashboard and the second dashboard, wherein the display device includes, a first low-curvature area on the first dashboard, a second low-curvature area on the second dashboard, a first high-curvature area between the first low-curvature area and the second low-curvature area, a first substrate including a first surface and a second surface facing each other and having a rigid material, a second substrate on the first surface of the first substrate and having a flexible material, and an emission material layer on the second substrate and including a plurality of light-emitting elements, wherein the first substrate further includes, an opening overlapping the first high-curvature area and exposing the second substrate, a first side surface located at an edge adjacent to the opening and located between the first surface and the second surface, and a first inclined surface between the first surface and the first side surface, and wherein the first high-curvature area overlaps with the emission material layer.

According to some embodiments, the automobile may further comprise, a third dashboard between the first dashboard and the second dashboard, wherein the display device comprises, a third low-curvature area located on the third dashboard and located between the first high-curvature area and the second low-curvature area, and a second high-curvature area located between the second low-curvature area and the third low-curvature area, and wherein the second high-curvature area overlaps with the opening and the emission material layer.

According to some embodiments, the automobile may further comprise, a center console on a lower side of the third dashboard, wherein the display device further comprises, a fourth low-curvature area located on the center console, and a third high-curvature area located between the third low-curvature area and the fourth low-curvature area, and wherein the third high-curvature area overlaps with the opening and the emission material layer.

According to some embodiments, the display device further comprises a fourth high-curvature area located at one end of the display device, and wherein the fourth high-curvature area is configured to be bent and coupled to a coupling structure formed in at least one of the first to third dashboards or the center console.

According to some embodiments, the coupling structure is a groove or an opening concaved into at least one of the first to third dashboards or the center console.

According to some embodiments, a step is between the first dashboard and the second dashboard by a level difference, and wherein the first high-curvature area overlaps with the step.

According to some embodiments, the first high-curvature area is configured to be bent along a shape of the step.

According to some embodiments, the first substrate comprises glass, and the second substrate comprises a polymer resin.

According to some embodiments of the present invention, a display device may have a relatively improved aesthetic appeal and provide a relatively improved user experience by achieving a high-curvature shape.

According to some embodiments of the present invention, it may be possible to improve the surface quality of a display device.

It should be noted that characteristics of embodiments according to the present invention are not limited to those described above and other effects of embodiments according to the present invention will be more apparent to those skilled in the art from the following descriptions.

### BRIEF DESCRIPTION OF THE DRAWINGS

The above and other aspects and features of embodiments according to the present invention will become more apparent by describing in more detail aspects of some embodiments thereof with reference to the attached drawings, in which:
FIG. 1 is a perspective view showing an example of an electronic device according to some embodiments of the present invention.
FIG. 2 is a plan view showing an example of the display device according to some embodiments of the present invention.
FIG. 3 is a cross-sectional view of a display device according to some embodiments of the present invention.
FIG. 4 is a cross-sectional view taken along the line X1 - X1' in FIG. 2.
FIG. 5 is a cross-sectional view showing the display device of FIG. 4 when it is bent.
FIG. 6 is a cross-sectional view showing a display device according to some embodiments of the present invention.
FIG. 7 is a cross-sectional view showing the display device of FIG. 6 when it is bent.
FIG. 8 is a cross-sectional view showing a display device according to some embodiments of the present invention.
FIG. 9 is a cross-sectional view showing the display device of FIG. 8 when it is bent.
FIGS. 10 and 11 are cross-sectional views showing a display device according to some embodiments of the present invention.
FIG. 12 is a cross-sectional view showing a display device according to some embodiments of the present invention.
FIG. 13 is a flowchart for illustrating a method of fabricating a display device according to some embodiments of the present invention.
FIG. 14 is a cross-sectional view showing step S100 of FIG. 13.
FIG. 15 is a cross-sectional view showing step S200 of FIG. 13.
FIG. 16 is a cross-sectional view showing step S300 of FIG. 13.
FIG. 17 is a cross-sectional view showing step S400 of FIG. 13.
FIG. 18 is a cross-sectional view showing step S500 of FIG. 13.
FIG. 19 is a cross-sectional view showing step S600 of FIG. 13.

### DETAILED DESCRIPTION

Aspects of some embodiments of the present invention will now be described more fully hereinafter with reference to the accompanying drawings, in which aspects of some embodiments of the invention are shown. This invention may, however, be embodied in different forms and should not be construed as limited to the embodiments set forth herein. Rather, these embodiments are provided so that this invention will be thorough and complete, and will filly convey the scope of the invention to those skilled in the art.

It will also be understood that when a layer is referred to as being "on" another layer or substrate, it can be directly on the other layer or substrate, or intervening layers may also be present. The same reference numbers indicate the same components throughout the specification.

Hereinafter, embodiments of the present invention will be described in more detail with reference to the accompanying drawings.

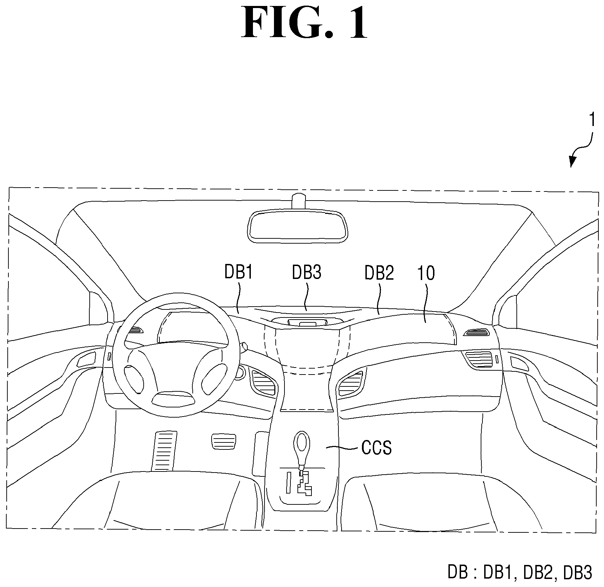

FIG. 1 is a perspective view showing an example of an electronic device according to some embodiments of the present invention.

Referring to FIG. 1, an electronic device 1 displays moving images (e.g., video images) or still images (e.g., static images). The electronic device 1 may refer to any electronic device that includes a display screen. For example, the electronic device 1 may include a television set, a laptop computer, a monitor, an electronic billboard, the Internet of Things devices, a mobile phone, a smart phone, a tablet personal computer (PC), an electronic watch, a smart watch, a watch phone, a head-mounted display device, a mobile communications terminal, an electronic notebook, an electronic book, a portable multimedia player (PMP), a navigation device, a game console and a digital camera, a camcorder, etc. FIG. 1 shows an automobile as an example of the electronic device 1.

The electronic device 1 may include a display device 10 that includes a display screen. Examples of the display device 10 may include an inorganic light-emitting diode display device, an organic light-emitting display device, a quantum-dot light-emitting display device, a plasma display device, a field emission display device, etc. In the following description, an organic light-emitting diode display device is employed as an example of the display device, but embodiments according to the present invention are not limited thereto. Any other display device may be employed as long as the technical idea of the present invention can be equally applied.

The shape of the electronic device 1 may be modified in a variety of ways. For example, as shown in FIG. 1, when the electronic device 1 is employed by an automobile, the electronic device 1 may include a dashboard DB and a center console CCS. The shapes of the dashboard DB and the center console CCS of the electronic device 1 may be modified in a variety of ways depending on the shape of the vehicle body.

The dashboard DB may provide a variety of information on In-Vehicle Infotainment system for automobiles to a driver and other passengers. The In-Vehicle Infotainment system refers to a system that provides information and entertainment to a driver and other passengers by integrating in-vehicle and external systems. The In-Vehicle Infotainment system may include all devices or technologies that provide a variety of services with mobile devices, including the Internet access, movies, games, television programs, social network services (SNS), GPS navigation, etc.

The dashboard DB may include a first dashboard DB1 located in front of a driver's seat, a second dashboard DB2 located in front of a passenger seat, and a third dashboard DB3 located between the first dashboard DB1 and the second dashboard DB2. The first dashboard DB1, the second dashboard DB2 and the third dashboard DB3 may be parts of the dashboard DB.

According to some embodiments of the present invention, the first dashboard DB1 may include an instrument cluster to provide the driver with a variety of information necessary for driving, such as speed information and vehicle condition information. For example, the first dashboard DB1 may include a digital cluster.

According to some embodiments of the present invention, the third dashboard DB3 may provide map information, music information, temperature information, etc. The third dashboard DB3 may provide a variety of options for manipulating convenience features that assist driving. For example, the third dashboard DB3 may include a center information display (CID).

According to some embodiments of the present invention, the second dashboard DB2 may provide the information of the first dashboard DB1 and the third dashboard DB3 to the passenger in the passenger seat. For example, the second dashboard DB2 may include a front passenger seat display (co-driver display).

The center console CCS may be located below the third dashboard DB3. The center console CCS may be located between the driver's seat and the front passenger's seat. According to some embodiments of the present invention, the center console CCS may include a variety of functional members for controlling the driving manner of the vehicle, such as a gear shift lever, a parking brake, and a drive mode button. Although the gear shift lever and the like are operated manually by physical manipulation in the drawings, the present invention is not limited thereto. For example, the display device 10 may include an input device such as a touch panel, so that the display device 10 may be operated digitally by control buttons on the display device 10.

The information provided from the first to third dashboards DB1, DB2 and DB3 and the center console CCS is not limited to a particular one. The information provided from one of the first to third dashboards DB1, DB2 and DB3 and the center console CCS may be provided from the others.

According to some embodiments, the dashboard DB and the center console CCS may further include a coupling structure for accommodating the display device 10. For example, the coupling structure may be a groove or an opening into which at least a part of the display device 10 may be inserted. The coupling structure may be a groove or an opening concaved into the dashboard DB and the center console CCS.

The electronic device 1 according to some embodiments may provide a user with a variety of information through the display device 10 located on the first to third dashboards DB1, DB2 and DB3 and the center console CCS, or a user may manipulate other components included in the electronic device 1 based on information input through the display device 10.

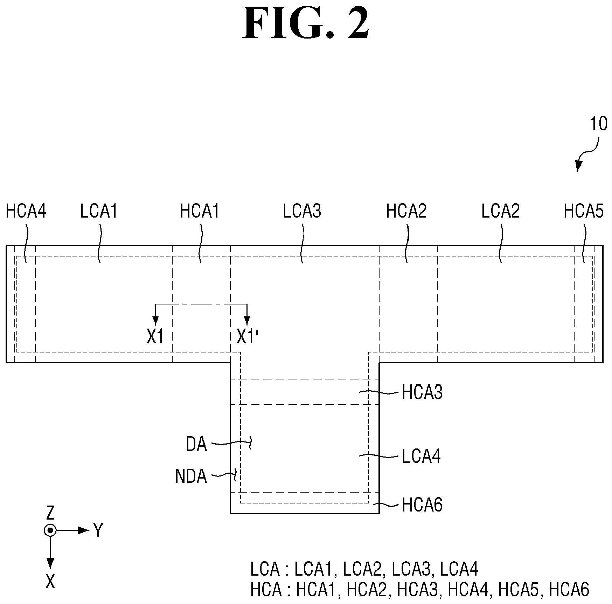

FIG. 2 is a plan view showing an example of the display device 10 according to some embodiments of the present invention.

Referring to FIG. 2 in conjunction with FIG. 1, the display device 10 may include a display area DA and a non-display area NDA. In the display area DPA, images can be displayed. In the non-display area NDA, images are not displayed. The display area DA may be referred to as an active area, while the non-display area NDA may also be referred to as an inactive area. The display device 10 may have a T-shape, in particular to be located in the first to third dashboards DB1, DB2, DB3.

The display area DA may generally occupy the center of the display device 10. Light may be output from a plurality of emission areas or a plurality of open areas. For example, in the display area DA, pixel circuits including switching elements, a pixel-defining film that defines the emission areas or the open areas, and self-light-emitting elements may be located.

For example, the self-light-emitting element may include, but is not limited to, at least one of: an organic light-emitting diode including an organic emissive layer, a quantum-dot light-emitting diode (quantum LED) including a quantum-dot emissive layer, an inorganic light-emitting diode (inorganic LED) including an inorganic semiconductor, or a micro light-emitting diode (micro LED).

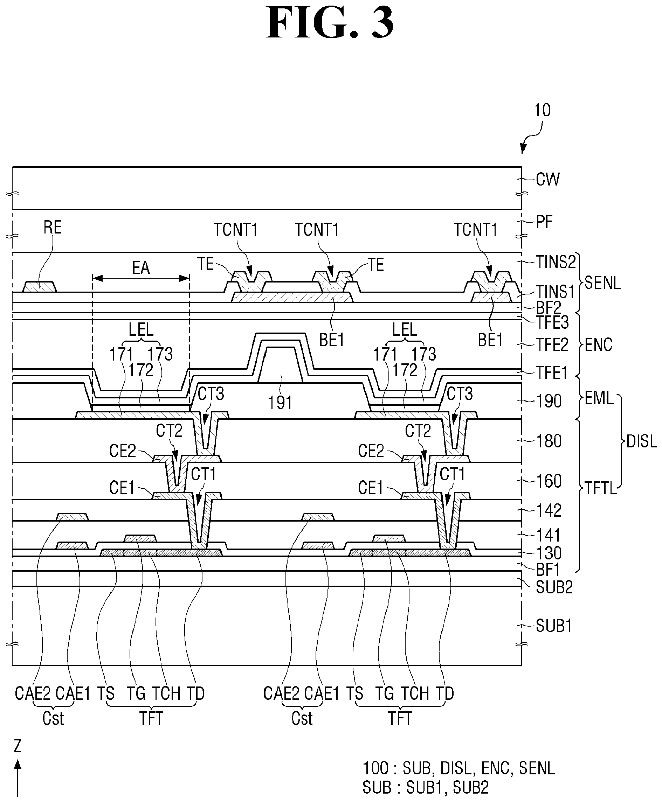

The non-display area NDA may surround (e.g., in a periphery or outside a footprint of) the display area DA. The non-display area NDA may include a gate driver, a display driver, and a touch driver. The gate driver may provide gate voltages to gate lines. The display driver may output signals and voltages for driving the display panel 100 (see FIG. 3). The display driver may provide data voltages to data lines. The display driver may provide supply voltages to voltage lines and may supply gate control signals to the gate driver. The touch driver may be connected to a touch sensing unit of the display panel 100 (see FIG. 3). The touch driver may provide touch driving signals to a plurality of touch electrodes of the touch sensing unit and may sense a change in the capacitance between the plurality of touch electrodes.

The gate driver, the display driver and the touch driver may be mounted directly on the display panel 100 (see FIG. 3) or may be mounted on a circuit board attached to the display panel 100 (see FIG. 3). Each of the gate driver, the display driver and the touch driver may be implemented as an integrated circuit (IC) and may be mounted on the display panel 100 (see FIG. 3) by a chip-on-glass (COG) technique, a chip-on-plastic (COP) technique, or ultrasonic bonding.

In some embodiments, when the electronic device 1 is employed by an automobile, the display device 10 may be an in-vehicle display. The in-vehicle display may provide a user with a variety of service information such as convenience functions and media information as well as drive information and status information of the vehicle. When the display device 10 includes an input device such as a touch panel, a user may manipulate a variety of features, such as the drive modes of the vehicle and the convenience functions, through the display device 10.

In some embodiments, the display device 10 may be extended in a first direction (x-axis direction) and a second direction (y-axis direction). For example, the display device 10 may include extended portions in the second direction (y-axis direction), and a protruding portion extended in the first direction (x-axis direction) from the center of the extended portions in the second direction (y-axis direction). That is to say, the display device 10 may have, but is not limited to, a generally T shape.

In the drawings, the first direction (x-axis direction) and the second direction (y-axis direction) intersect each other as the horizontal directions. For example, the first direction (x-axis direction) and the second direction (y-axis direction) may be orthogonal to each other. In addition, the third direction (z-axis direction) may intersect the first direction (x-axis direction) and the second direction (y-axis direction), and may be, for example, a vertical direction orthogonal to them. Herein, the side indicated by the arrow of each of the first to third directions (x-axis direction, y-axis direction and z-axis direction) may be referred to as a first side, while the opposite side may be referred to as a second side.

The display device 10 may include high-curvature areas HCA and low-curvature areas LCA. The high-curvature areas HCA may have smaller minimum radii of curvature than the low-curvature areas LCA. For example, the minimum radii of curvature of the high-curvature areas HCA may be equal to or less than approximately 10 mm, while the minimum radii of curvature of the low-curvature areas LCA may be equal to or greater than approximately 10 mm. The minimum radius of curvature may be the reciprocal of the maximum curvature. Accordingly, the high-curvature area HCA may have a greater maximum curvature than the low-curvature area LCA. The maximum curvature may mean that the maximum value of curvature that does not cause defects, e.g., cracks in the elements such as the substrate SUB (see FIG. 3) and a display layer DISL (see FIG. 3) included in the display device 10, or does not deteriorate the quality of the display device 10.

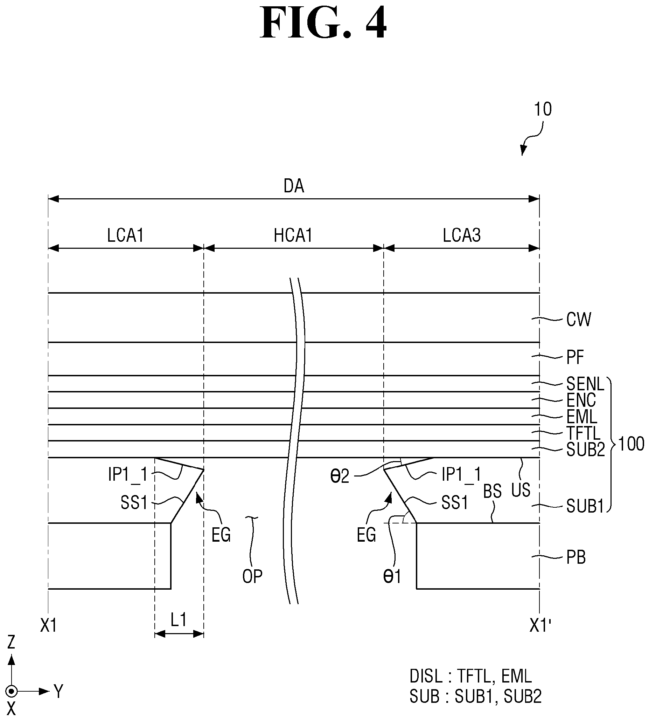

The high-curvature areas HCA may refer to areas from which a portion of a first substrate SUB1 (see FIG. 4), which will be described later, is removed. The low-curvature areas LCA may refer to areas where the first substrate SUB1 (see FIG. 4) remains.

The high-curvature area HCA may overlap the display area DA in the third direction (z-axis direction). For example, the high-curvature area HCA may display images through light emitted from light-emitting elements located in the display area DA. According to some embodiments, the images can be displayed even in the high-curvature areas HCA of the display device 10 at which a part of the display device 10 is bent, so that aesthetic appeal of the display device 10 can be improved, users can get more immerged into the contents, and a wider display screen can be provided to the users.

According to some embodiments of the present invention, the display device 10 may include first to fourth low-curvature areas LCA1, LCA2, LCA3 and LCA4, and first to sixth high-curvature areas HCA1, HCA2, HCA3, HCA4, HCA5 and HCA6.

The third low-curvature area LCA3 may be located between the first low-curvature area LCA1 and the second low-curvature area LCA2 in the second direction (y-axis direction). The fourth low-curvature area LCA2 may be located on one side of the third low-curvature area LCA3 in the first direction (x-axis direction), for example, on the lower side of the third low-curvature area LCA3 in the drawings.

The first low-curvature area LCA1 may be located on the first dashboard DB1. The second low-curvature area LCA2 may be located on the second dashboard DB2. The third low-curvature area LCA3 may be located on the third dashboard DB3. The fourth low-curvature area LCA4 may be located on the center console CCS.

The first high-curvature area HCA1 may be located between the first low-curvature area LCA1 and the third low-curvature area LCA3 in the second direction (y-axis direction). The second high-curvature area HCA2 may be located between the second low-curvature area LCA2 and the third low-curvature area LCA3 in the second direction (y-axis direction). The third high-curvature area HCA3 may be located between the fourth low-curvature area LCA4 and the third low-curvature area LCA3 in the first direction (x-axis direction). The fourth high-curvature area HCA4 may be located on the opposite side of the first low-curvature area LCA1 in the second direction (y-axis direction). The fifth high-curvature area HCA5 may be located on one side of the second low-curvature area LCA2 in the second direction (y-axis direction). The sixth high-curvature area HCA6 may be located on one side of the fourth low-curvature area LCA4 in the first direction (x-axis direction).

The fourth to sixth high-curvature areas HCA4, HCA5 and HCA6 may be located at the ends of the display device, respectively. For example, the fourth high-curvature area HCA4 may be located at the opposite end of the display device 10 in the second direction (y-axis direction). The fifth high-curvature area HCA5 may be located at the end of the display device 10 in the second direction (y-axis direction). The sixth high-curvature area HCA6 may be located at the end of the display device 10 in the first direction (x-axis direction).

The first high-curvature area HCA1 may be arranged across the first dashboard DB1 and the third dashboard DB3. The second high-curvature area HCA2 may be arranged across the second dashboard DB2 and the third dashboard DB3. The third high-curvature area HCA3 may be arranged across the center console CCS and the third dashboard DB3. The fourth high-curvature area HCA4 may be located on the first dashboard DB1. The fifth high-curvature area HCA5 may be located on the second dashboard DB2. The sixth high-curvature area HCA6 may be located on the center console CCS.

The high-curvature areas HCA may overlap steps located between the first to third dashboards DB1, DB2 and DB3 and the center console CCS, respectively. For example, the first to third dashboards DB1, DB2 and DB3 and the center console CCS may include steps therebetween. The steps may be created by the shape of the vehicle and the shapes of other members. In the high-curvature area HCA, the display device 10 may be bent along the steps.

For example, in each of the first to third high-curvature areas HCA1, HCA2 and HCA3, the display device 10 may be bent along the step between the first and third dashboards DB1 and DB3, the step between the second and third dashboards DB2 and DB3, and the step between the third dashboard DB3 and the center console CCS. At the fourth and fifth high-curvature areas HCA4 and HCA5, the display device 10 may be bent and fitted or inserted into a coupling structure formed in the dashboard DB. At the sixth high-curvature area HCA6, the display device 10 may be bent and fitted or inserted into a coupling structure formed in the center console CCS.

The display device 10 according to some embodiments may be a single integrated display device in which the first to fourth low-curvature areas LCA1, LCA2, LCA3 and LCA4 and the first to sixth high-curvature areas HCA1, HCA2, HCA3, HCA4, HCA5 and HCA6 are physically connected with one another. As described above, the display device 10 according to some embodiments can be implemented as a single integrated display by including the high-curvature areas HCA despite the steps created by the shapes of the other member or the shape of the coupling structure. Accordingly, the aesthetic appeal can be relatively improved, and a more compelling user experience can be provided. On the other hand, the surface quality can be improved by including the low-curvature areas LCA. Accordingly, the display device 10 can be relatively more reliably coupled with the electronic device 1 or other components of the electronic device 1.

Although the four low-curvature areas LCA and the six high-curvature areas HCA have been described as an example herein, the present invention is not limited thereto. The numbers and arrangement of the low-curvature areas LCA and the high-curvature areas HCA may vary depending on the shape of the electronic device 1. In addition, although the display device 10 for an automobile has been described as an example, the present invention is not limited thereto.

FIG. 3 is a cross-sectional view of a display device according to some embodiments of the present invention.

Referring to FIG. 3, the display device 10 may include a display panel 100, a polarizing film PF, and a cover window CW.

The display panel 100 may be an organic light-emitting display panel including light-emitting elements LEL each including an organic emissive layer 172. It should be understood, however, that the present invention is not limited thereto. The display panel 110 may be a light-emitting display panel such as a quantum-dot light-emitting display panel including a quantum-dot emissive layer, an inorganic light-emitting display panel including an inorganic semiconductor, and a micro light-emitting display panel using micro or nano light-emitting diodes (micro LEDs or nano LEDs). In the following description, an organic light-emitting display panel is employed as an example of the display panel 100 for convenience of illustration.

The display panel 100 may include a substrate SUB, a display layer DISL, an encapsulation layer ENC, and a sensor electrode layer SENL.

The substrate SUB may include a first substrate SUB1 made of a rigid material, and a second substrate SUB2 made of a flexible material.

The first substrate SUB1 may have a rigid material. For example, the first substrate SUB1 may be made of glass. The first substrate SUB1 may be formed of ultra thin glass (UTG) having a thickness of approximately 500 µm or less. According to some embodiments, the first substrate SUB1 may have a thickness of approximately 200 µm.

The second substrate SUB2 may have a flexible material. The second substrate SUB2 may be made of a polymer resin having a thickness smaller than that of the first substrate SUB1. For example, the second substrate SUB2 may have a thickness of approximately 20 µm or less. The second substrate SUB2 may be formed of an organic material such as an acryl resin, an epoxy resin, a phenolic resin, a polyamide resin and a polyimide resin. Because the second substrate SUB2 is made of a polymer resin, it may be referred to as a plastic substrate. In some embodiments, the second substrate SUB2 may have a multi-layer structure.

The display layer DISL may include a thin-film transistor layer TFTL including a plurality of thin-film transistors and an emission material layer EML including a plurality of light-emitting elements.

The thin-film transistor layer TFTL may include a first buffer film BF1, a thin-film transistor TFT, a gate insulator 130, a first interlayer dielectric film 141, a capacitor Cst, a second interlayer dielectric film 142, a first data metal layer, a first organic film 160, a second data metal layer, and a second organic film 180.

The first buffer film BF1 may be located on the substrate SUB. The first buffer film BF1 may be formed of an inorganic material such as a silicon nitride layer, a silicon oxynitride layer, a silicon oxide layer, a titanium oxide layer, and an aluminum oxide layer. Alternatively, the first buffer film BF1 may be made up of multiple layers in which two or more of a silicon nitride layer, a silicon oxynitride layer, a silicon oxide layer, a titanium oxide layer and an aluminum oxide layer are stacked on one another.

An active layer including a channel region TCH, a source region TS and a drain region TD of the thin-film transistor TFT may be located on the first buffer film BF1. The active layer may be made of polycrystalline silicon, monocrystalline, low-temperature polycrystalline silicon, amorphous silicon, or an oxide semiconductor. When the active layer includes polycrystalline silicon or an oxide semiconductor material, the source region TS and the drain region TD in the active layer may be conductive regions doped with ions or impurities to have conductivity.

The gate insulator 130 may be located on the active layer of the thin-film transistor TFT. The gate insulator 130 may be formed of an inorganic layer, for example, a silicon nitride layer, a silicon oxynitride layer, a silicon oxide layer, a titanium oxide layer, or an aluminum oxide layer.

A first gate metal layer including a gate electrode TG of the thin-film transistor TFT, a first capacitor electrode CAE1 of a capacitor Cst, and scan lines may be located on the gate insulator 130. The gate electrode G of the thin-film transistor TFT may overlap the channel region TCH in the third direction (z-axis direction). The first gate metal layer may be made up of a single layer or multiple layers of one of molybdenum (Mo), aluminum (Al), chromium (Cr), gold (Au), titanium (Ti), nickel (Ni), neodymium (Nd) and copper (Cu) or an alloy thereof.

The first interlayer dielectric film 141 may be located on the first gate metal layer. The first interlayer dielectric film 141 may be formed of an inorganic layer, for example, a silicon nitride layer, a silicon oxynitride layer, a silicon oxide layer, a titanium oxide layer, or an aluminum oxide layer. The first interlayer dielectric film 141 may include a number of inorganic layers.

The second gate metal layer including a second capacitor electrode CAE2 of the capacitor Cst may be located on the first interlayer dielectric film 141. The second capacitor electrode CAE2 may overlap the first capacitor electrode CAE1 in the third direction (z-axis direction). Therefore, the capacitor Cst may be formed by the first capacitor electrode CAE1, the second capacitor electrode CAE2, and an inorganic insulating dielectric film located therebetween and serving as a dielectric film. The second gate metal layer may be made up of a single layer or multiple layers of one of molybdenum (Mo), aluminum (Al), chromium (Cr), gold (Au), titanium (Ti), nickel (Ni), neodymium (Nd) and copper (Cu) or an alloy thereof.

A second interlayer dielectric film 142 may be located on the second gate metal layer. The second interlayer dielectric film 142 may be formed of an inorganic layer, for example, a silicon nitride layer, a silicon oxynitride layer, a silicon oxide layer, a titanium oxide layer, or an aluminum oxide layer. The second interlayer dielectric film 142 may include a number of inorganic layers.

The first data metal layer including first connection electrodes CE1 and data lines may be located on the second interlayer dielectric film 142. The first connection electrode CE1 may be connected to the drain region TD through a first contact hole CT1 penetrating the gate insulator 130, the first interlayer dielectric film 141 and the second interlayer dielectric film 142. The first data metal layer may be made up of a single layer or multiple layers of one of molybdenum (Mo), aluminum (Al), chromium (Cr), gold (Au), titanium (Ti), nickel (Ni), neodymium (Nd) and copper (Cu) or an alloy thereof.

A first organic film 160 may be arranged over the first connection electrode CE1 for providing a flat surface over the thin-film transistors TFT having uneven heights. The first organic film 160 may be formed as an organic layer such as an acryl resin, an epoxy resin, a phenolic resin, a polyamide resin and a polyimide resin.

A second data metal layer including second connection electrodes CE2 may be located on the first organic film 160. The second data metal layer may be connected to the first connection electrode CE1 through a second contact hole CT2 penetrating the first organic film 160. The second data metal layer may be made up of a single layer or multiple layers of one of molybdenum (Mo), aluminum (Al), chromium (Cr), gold (Au), titanium (Ti), nickel (Ni), neodymium (Nd) and copper (Cu) or an alloy thereof.

The second organic film 180 may be located on the second connection electrode CE2. The second organic film 180 may be formed as an organic layer such as an acryl resin, an epoxy resin, a phenolic resin, a polyamide resin and a polyimide resin.

It should be noted that the second data metal layer including the second connection electrodes CE2 and the second organic film 180 may be eliminated.

The emission material layer EML is located on the thin-film transistor layer TFTL. The emission material layer EML may include light-emitting elements LEL and a pixel-defining film 190.

Each of the light-emitting elements LEL may include a pixel electrode 171, an emissive layer 172, and a common electrode 173. In each of the emission areas EA, the pixel electrode 171, the emissive layer 172 and the common electrode 173 are stacked on one another sequentially, so that holes from the pixel electrode 171 and electrons from the common electrode 173 are combined with each other in the emissive layer 172 to emit light. In such case, the pixel electrode 171 may be an anode electrode while the common electrode 173 may be a cathode electrode.

A pixel electrode layer including the pixel electrode 171 may be formed on the second organic film 180. The pixel electrode 171 may be connected to the second connection electrode CE2 through a third contact hole CT3 penetrating the second organic film 180. The pixel electrode layer may be made up of a single layer or multiple layers of one of molybdenum (Mo), aluminum (Al), chromium (Cr), gold (Au), titanium (Ti), nickel (Ni), neodymium (Nd) and copper (Cu) or an alloy thereof.

In the top-emission structure where light exits from the emissive layer 172 toward the common electrode 173, the pixel electrode 171 may be made up of a single layer of molybdenum (Mo), titanium (Ti), copper (Cu) or aluminum (Al), or may be made up of a stack structure of aluminum and titanium (Ti/Al/Ti), a stack structure of aluminum and ITO (ITO/AI/ITO), an APC alloy and a stack structure of APC alloy and ITO (ITO/APC/ITO) in order to increase the reflectivity. The APC alloy is an alloy of silver (Ag), palladium (Pd) and copper (Cu).

The pixel-defining film 190 may define the emission areas EA of the pixels. To this end, the pixel-defining film 190 may be formed on the second organic film 180 to expose a part of the pixel electrode 171. The pixel-defining film 190 may cover the edges of the pixel electrode 171. The pixel-defining film 190 may be located inside the third contact hole CT3. In other words, the third contact hole CT3 may be filled with the pixel-defining film 190. The pixel-defining film 190 may be formed of an organic layer such as an acryl resin, an epoxy resin, a phenolic resin, a polyamide resin and a polyimide resin.

A spacer 191 may be located on the pixel-defining film 190. The spacer 191 may support a mask during a process of fabricating the emissive layer 172. The spacer 191 may be formed of an organic layer such as an acryl resin, an epoxy resin, a phenolic resin, a polyamide resin and a polyimide resin.

The emissive layer 172 is formed on the pixel electrode 171. The emissive layer 172 may include an organic material to emit light of a certain color. For example, the emissive layer 172 may include a hole transporting layer, an organic material layer, and an electron transporting layer. The organic material layer may include a host and a dopant. The organic material layer may include a material that emits a light (e.g., a set or predetermined light), and may be formed using a phosphor or a fluorescent material.

The common electrode 173 is formed on the emissive layer 172. The common electrode 173 may be formed to cover the emissive layer 172. The common electrode 173 may be a common layer formed across the emission areas EA. A capping layer may be formed on the common electrode 173.

In the top-emission structure, the common electrode 173 may be formed of a transparent conductive material (TCP) such as ITO and IZO that can transmit light, or a semi-transmissive conductive material such as magnesium (Mg), silver (Ag) and an alloy of magnesium (Mg) and silver (Ag). When the common electrode 173 is formed of a semi-transmissive metal material, the light extraction efficiency can be increased by using microcavities.

The encapsulation layer ENC may be located on the emission material layer EML. The encapsulation layer ENC may include one or more inorganic films TFE1 and TFE3 to prevent permeation of oxygen or moisture into the emission material layer EML. In addition, the encapsulation layer ENC may include at least one organic film in order to protect the emission material layer EML from particles such as dust. For example, the encapsulation layer ENC may include a first inorganic encapsulation film TFE1, an organic encapsulation film TFE2 and a second inorganic encapsulation film TFE3.

The first inorganic encapsulation film TFE1 may be located on the common electrode 173, the organic encapsulation film TFE2 may be located on the first inorganic encapsulation film TFE1, and the second inorganic encapsulation film TFE3 may be located on the organic encapsulation film TFE2. The first inorganic encapsulation film TFE1 and the second inorganic encapsulation film TFE3 may be made up of multiple layers in which one or more inorganic layers of a silicon nitride layer, a silicon oxynitride layer, a silicon oxide layer, a titanium oxide layer and an aluminum oxide layer are alternately stacked on one another. The organic encapsulation film TFE2 may be an organic film such as an acryl resin, an epoxy resin, a phenolic resin, a polyamide resin, a polyimide resin, etc.

The sensor electrode layer SENL may be located on the encapsulation layer ENC. The sensor electrode layer SENL may include a second buffer film BF2, a first bridge BE1, a first sensor insulating film TINS1, sensor electrodes TE and RE, and a second sensor insulating film TINS2.

A second buffer film BF2 may be located on the encapsulation layer ENC. The second buffer film BF2 may include at least one inorganic film. For example, the second buffer film BF2 may be made up of multiple layers in which one or more inorganic layers of a silicon nitride layer, a silicon oxynitride layer, a silicon oxide layer, a titanium oxide layer and an aluminum oxide layer are alternately stacked on one another. The second buffer film BF2 may be eliminated.

First bridges BE1 may be located on the second buffer film BF2. The first bridges BE1 may be made up of a single layer of molybdenum (Mo), titanium (Ti), copper (Cu) or aluminum (Al), or may be made up of a stack structure of aluminum and titanium (Ti/Al/Ti), a stack structure of aluminum and ITO (ITO/AI/ITO), an APC alloy and a stack structure of an APC alloy and ITO (ITO/APC/ITO).

A first sensor insulating film TINS1 may be located on the first bridges BE1. The first sensor insulating film TINS1 may be formed of an inorganic layer, for example, a silicon nitride layer, a silicon oxynitride layer, a silicon oxide layer, a titanium oxide layer, or an aluminum oxide layer.

The sensor electrodes, i.e., driving electrodes TE and sensing electrodes RE may be located on the first sensor insulating film TINS1. In addition, dummy patterns may be located on the first sensor insulating film TNIS1. The driving electrodes TE, the sensing electrodes RE and the dummy patterns do not overlap the emission areas EA. The driving electrodes TE, the sensing electrodes RE and the dummy patterns may be made up of a single layer of molybdenum (Mo), titanium (Ti), copper (Cu) or aluminum (Al), or may be made up of a stack structure of aluminum and titanium (Ti/Al/Ti), a stack structure of aluminum and ITO (ITO/AI/ITO), an APC alloy and a stack structure of an APC alloy and ITO (ITO/APC/ITO).

The second sensor insulating film TINS2 may be located on the driving electrodes TE, the sensing electrodes RE, and the dummy patterns. The second sensor insulating film TINS2 may include at least one of an inorganic film or an organic film. The inorganic film may be a silicon nitride layer, a silicon oxynitride layer, a silicon oxide layer, a titanium oxide layer, or an aluminum oxide layer. The organic film may be an acryl resin, an epoxy resin, a phenolic resin, a polyamide resin and a polyimide resin.

The polarizing film PF may be located on the sensor electrode layer SENL. The polarizing film PF may be located on the display panel 100 in order to reduce reflection of external light. The polarizing film PF may include a first base member, a linear polarizer, a retardation film such as a λ/4 (quarter-wave) plate, and a second base member. The first base member, the retardation film, the linear polarizer and the second base member of the polarizing film PF may be sequentially stacked on the display panel 100.

The cover window CW may be located on the polarizing film PF. The cover window CW may be attached onto the polarizing film PF by a transparent adhesive member such as an optically clear adhesive (OCA) film.

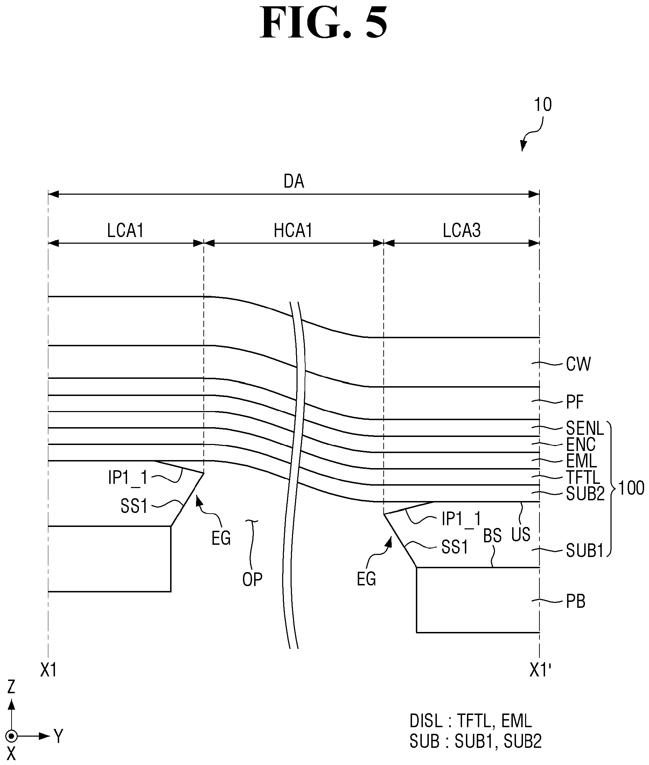

FIG. 4 is a cross-sectional view taken along line X1 - X1' in FIG. 2. FIG. 5 is a cross-sectional view showing the display device of FIG. 4 when it is bent. FIGS. 4 and 5 are cross-sectional views showing the display area DA at the first high-curvature area HCA1, the first low-curvature area LCA1, and the third low-curvature area LCA3. Hereinafter, although only the first high-curvature area HCA1, the first low-curvature area LCA1 and the third low-curvature area LCA3 will be described as an example, it is to be understood that the description may be equally applied to the other low-curvature areas LCA and high-curvature areas HCA.

Referring to FIGS. 4 and 5 in conjunction with FIGS. 1 and 2, the display device 10 may further include a panel bottom cover PB in addition to the display panel 100, the polarizing film PF and the cover window CW. The display panel 100 may include a substrate SUB, a display layer DISL, an encapsulation layer ENC, and a sensor electrode layer SENL.

The display layer DISL, the encapsulation layer ENC, the sensor electrode layer SENL, the polarizing film PF and the cover window CW have been described above; and, therefore, the redundant descriptions will be omitted.

The panel bottom cover PB may be located on a second surface of the substrate SUB of the display panel 100. The second surface of the substrate SUB may be opposite to the first surface. For example, the panel bottom cover PB may be located on the lower surface BS of the substrate SUB. The second surface may be also called bottom surface BA. The panel bottom cover PB may be attached to the second surface of the substrate SUB of the display panel 100 by an adhesive member. The adhesive member may be a pressure-sensitive adhesive (PSA).

The panel bottom cover PB may include at least one of: a light-blocking member for absorbing light incident from outside, a buffer member for absorbing external impact, or a heat dissipating member for efficiently discharging heat from the display panel 100.

In the display device 10 according to some embodiments, the substrate SUB may include a first substrate SUB1 made of a rigid material, and a second substrate SUB2 made of a flexible material. The first substrate SUB1 may not be located in the high-curvature areas HCA but may be located in the low-curvature areas LCA. For example, as shown in the drawings, the first substrate SUB1 may not be located in the first high-curvature area HCA1 but may be located in the first low-curvature area LCA1 and the third low-curvature area LCA3. The first substrate SUB1 may include an opening OP exposing the second substrate SUB2.

In the display device 10 according to some embodiments, the first substrate SUB1 made of a rigid material is not located in the high-curvature areas HCA. Therefore, the display device 10 can be easily bent at the high-curvature areas HCA, as shown in FIG. 5. For example, the minimum radius of curvature of the high-curvature areas HCA may be equal to approximately 10 mm.

The high-curvature areas HCA may overlap with the display area DA. For example, the opening OP of the first substrate SUB1 may be located in the display area DA. The display device 10 according to some embodiments can be implemented as a single integrated display by locating the high-curvature areas HCA on the display area DA. Accordingly, the aesthetics quality can be improved, a more compelling user experience can be provided, and a wider display screen can be provided to the user.

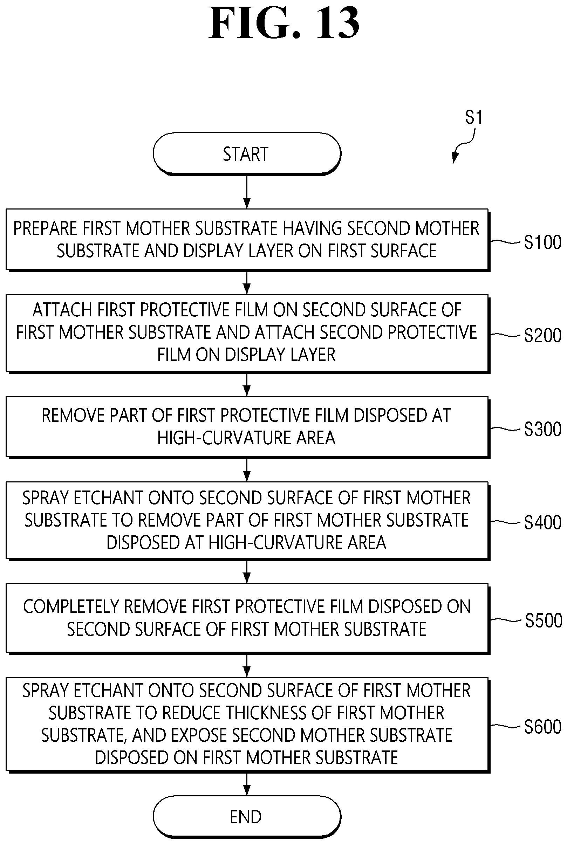

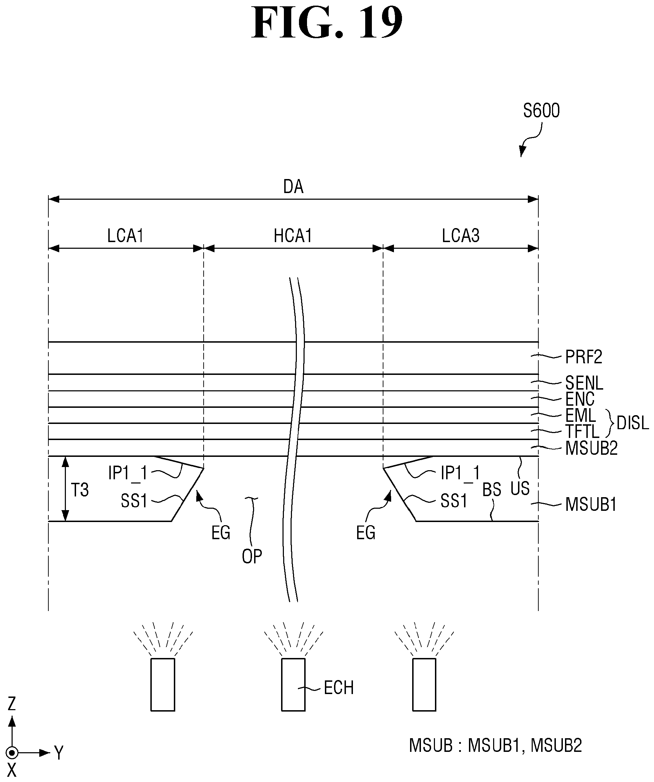

The first substrate SUB1 may include a first side surface SS1 and a first inclined surface IP1_1 at an edge EG adjacent to the first high-curvature area HCA1. The edge EG adjacent to the first high-curvature area HCA1 may refer to, for example, the edge adjacent to the opening OP that is formed by etching a part of a first mother substrate MSUB1 (see FIG. 19) on the first high-curvature area HCA1 according to a method S1 of fabricating a display device described below (see FIG. 13). That is to say, the first substrate SUB1 may include the first side surface SS1 and the first inclined surface IP1_1 at the edge EG adjacent to the opening OP.

For example, the first substrate SUB1 may include an upper surface US, a lower surface BS, and a first side surface SS1 and a first inclined surface IP1_1.

An upper surface US may also be called as the first surface. The upper surface US of the first substrate SUB1 may be a surface in the third direction (z-axis direction), and the lower surface BS of the first substrate SUB1 may be the opposite surface in the third direction (z-axis direction). The upper surface US and the lower surface BS may be parallel to each other. The upper surface US and the lower surface US may be the first surface and the second surface of the first substrate SUB1.

The first side surface SS1 may be located between the upper surface US and the lower surface BS. The first side surface SS1 may be located at the edge EG adjacent to the first high-curvature area HCA1. Thus, the first side surface may be located between the first surface and the second surface.

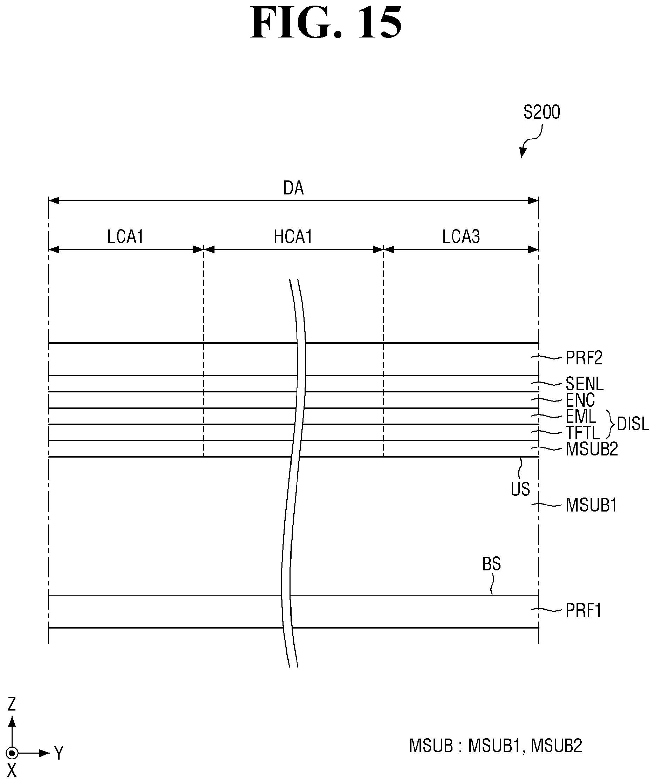

In some embodiments, the first side surface SS1 may be an inclined surface. For example, a first angle θ1, which is an acute angle between the lower surface BS and the first side surface SS1 of the first substrate SUB1, may be less than approximately 60 degrees. The first side surface may protrude further in the opening OP than the second surface, or the second side surface may protrude further in the opening OP than the first surface. The inclined surface of the first side surface SS1 may be formed by attaching a first protective film PRF1 (see FIG. 15) to etch a part of the first substrate SUB1 on the first high-curvature area HCA1 due to the isotropy of an etchant according to the method S1 of fabricating a display device to be described later (see FIG. 13).

The first inclined surface IP1_1 may be located between the upper surface US and the first side surface SS1. The first inclined surface IP1_1 may be an undercut formed between the first substrate SUB1 and the second substrate SUB2. An undercut may be understood as a slope connected to the upper surface US and/or located below the upper surface US. The first inclined surface IP1_1 and the upper surface US may be angled with a second angle θ2. The second angle θ2 may be an angle between the upper surface US and the first inclined surface IP1_1. The second angle θ2 may be smaller than the first angle θ1.

The first inclined surface IP1_1 may be formed as an etchant permeates into the interface between the first substrate SUB1 and the second substrate SUB2 and accordingly the first mother substrate MSUB1 is overly etched, according to the method S1 of fabricating a display device to be described later (see FIG. 13).

The first length L1, which is the length of the first inclined surface IP1_1 in the second direction (y-axis direction), may be equal to approximately 120 µm. The first length L1 may refer to the distance in the second direction (y-axis direction) from the end on the edge EG of the first substrate SUB1 that is adjacent to the first high-curvature area HCA1 to the boundary where the first inclined surface IP1_1 and the upper surface US of the first substrate SUB1 meet each other. A second angle θ2, which is an acute angle between the upper surface US and the first inclined surface IP1_1 of the first substrate SUB1, may be less than approximately 15 degrees.

In the display device 10 according to some embodiments, the opening OP of the first substrate SUB1 may overlap with the display area DA. That is to say, the high-curvature area HCA may overlap the display area DA in the third direction (z-axis direction). Accordingly, images can be displayed also on the high-curvature areas HCA through lights emitted from light-emitting elements located in the display area DA. According to some embodiments, the images can be displayed even in the high-curvature areas HCA of the display device 10 at which a part of the display device 10 is bent, so that aesthetic appeal of the display device 10 can be improved, users can get more immerged into the contents, and a wider display screen can be provided to the users.

In addition, as described above, the shape of the display device 10 according to some embodiments can be easily changed by including the high-curvature areas HCA despite the steps created by the shapes of the other member or the shape of the coupling structure. Accordingly, a single integrated display including a plurality of high-curvature areas HCA and a plurality of low-curvature areas LCA can be formed. For example, in the high-curvature areas HCA, the first substrate SUB1 made of a rigid material may not be formed but may include an opening OP, and only the second substrate SUB2 made of a flexible material may be formed. Accordingly, the display device 10 can have flexibility and can be implemented as a single integrated display in which the plurality of high-curvature areas HCA and the plurality of low-curvature areas LCA are connected with one another despite the steps therebetween. As a result, the aesthetics quality of the display device 10 can be improved, and a more compelling user experience can be provided.

On the other hand, the surface quality can be improved by including the low-curvature areas LCA. For example, the first substrate SUB1 made of a rigid material may be arranged except the high-curvature areas HCA to reduce the level differences. Because the first substrate SUB1 is rigid, the surface quality can be improved compared to a display panel including only the second substrate SUB2. Accordingly, the display device 10 can be more reliably coupled with the electronic device 1 or other components of the electronic device 1.

Hereinafter, display devices according to other embodiments of the present invention will be described. In the following description, the same or similar elements will be denoted by the same or similar reference numerals, and redundant descriptions will be omitted or briefly described.

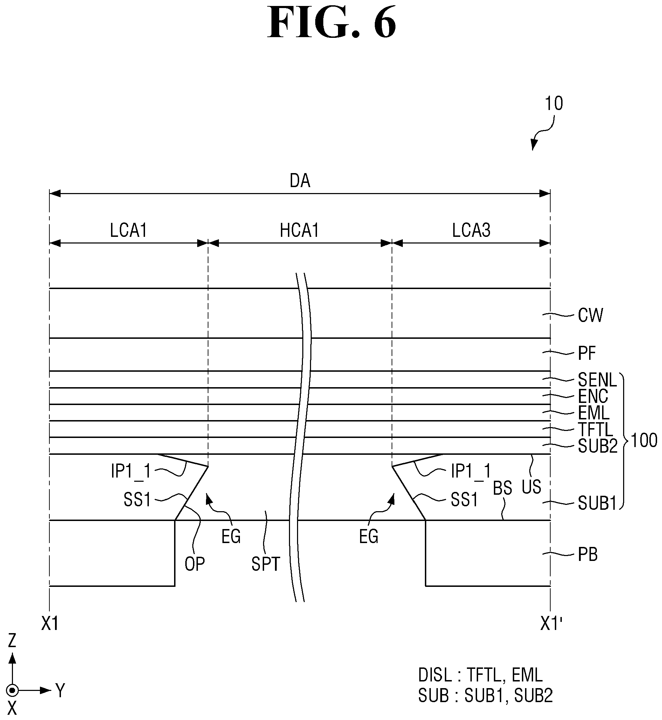

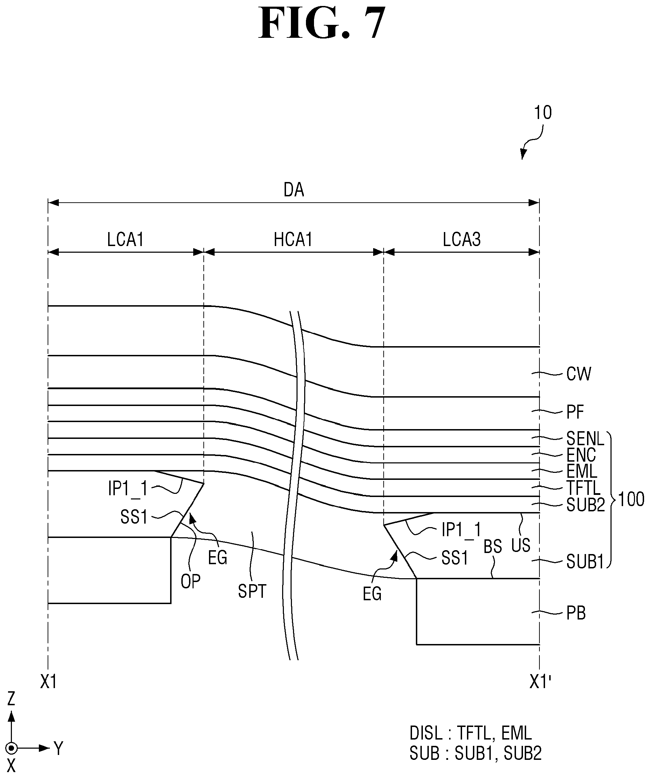

FIG. 6 is a cross-sectional view showing a display device according to some embodiments of the present invention. FIG. 7 is a cross-sectional view showing the display device of FIG. 6 when it is bent.

The embodiments of FIGS. 6 and 7 is different from the embodiments of FIG. 4 and the like in that a display device 10 further includes a support film SPT.

For example, the display device 10 according to some embodiments may further include the support film SPT. The support film SPT can protect and support the first substrate SUB1. In addition, the support film SPT may provide the flat lower surface BS of the first substrate SUB1.

The support film SPT may be located in the opening OP of the first substrate SUB1. The support film SPT may be located in the high-curvature areas HCA. For example, as shown in FIG. 6, the support film SPT may be located at the first high-curvature area HCA1. At least a part of the support film SPT may also be located in a groove formed between the first inclined surface IP1_1 and the upper surface US of the first substrate SUB1, that is, in the undercut.

According to some embodiments of the present invention, the lower surface of the support film SPT may be positioned at the same level as the lower surface BS of the first substrate SUB1. For example, the lower surface of the support film SPT may be positioned on the same plane as the lower surface BS of the first substrate SUB1. The lower surface of the support film SPT and the lower surface BS of the first substrate SUB1 may be arranged in parallel on the same plane defined by the first direction (x-axis direction) and the second direction (y-axis direction).

According to some embodiments of the present invention, the support film SPT may be an organic film. For example, the support film SPT may include at least one of: a polyurethane resin, a polyimide resin, a polyethylene resin, or a polypropylene resin. In some embodiments, the support film SPT may be filled via a dispensing process or an inkjet process.

In the display device 10 according to some embodiments, the first substrate SUB1 can be protected as the support film SPT is located in the opening OP of the first substrate SUB1 and the undercut. For example, The end on the edge EG of the first substrate SUB1 that is adjacent to the first high-curvature area HCA1, i.e., the tip can be protected, which is formed by the first side surface SS1 and the first inclined surface IP1_1 at the edge EG adjacent to the first high-curvature area HCA1..

In addition, in the display device 10 according to some embodiments, the lower surface of the support film SPT is positioned at the same level as the lower surface BS of the first substrate SUB1, so that the lower surface BS of the first substrate SUB1 can be flattened. In this manner, the surface quality of the lower surface BS of the first substrate SUB1 can be improved, so that another member can be more reliably coupled to the lower surface BS of the first substrate SUB1.

In addition, as shown in FIG. 7, when the display device 10 according to some embodiments is bent, the support force can be enhanced as the support film SPT is located in the first high-curvature area HCA1, so that the maximum curvature can be further improved. For example, when the support film SPT is located, the minimum radius of curvature of the first high-curvature area HCA1 may be equal to approximately 5 mm.

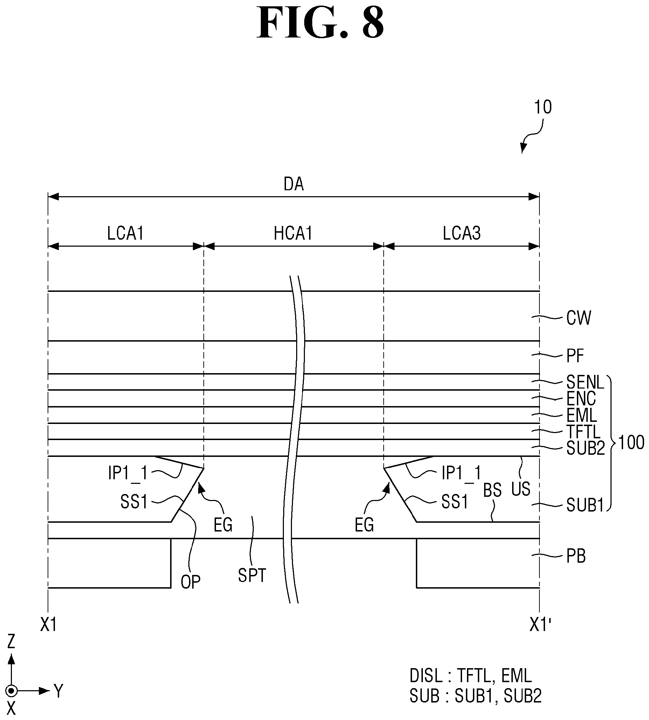

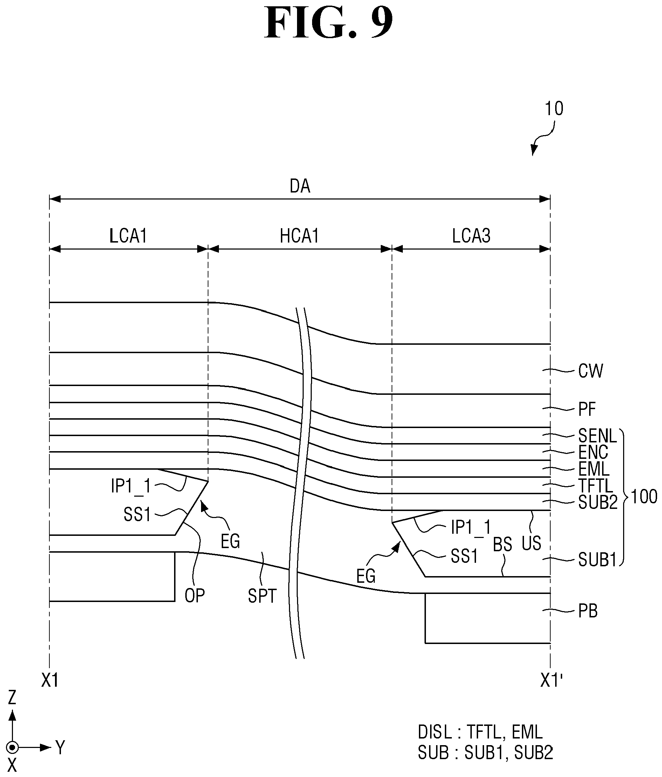

FIG. 8 is a cross-sectional view showing a display device according to some embodiments of the present invention. FIG. 9 is a cross-sectional view showing the display device of FIG. 8 when it is bent.

The embodiments of FIGS. 8 and 9 is different from the embodiments of FIG. 6 and the like in that a support film SPT is located also on the lower surface BS of the first substrate SUB1 in a display device 10.

For example, the support film SPT may be located on the lower surface BS of the first substrate SUB1 as well as inside the opening OP of the first substrate SUB1. For example, the support film SPT may be located in both the high-curvature areas HCA and the low-curvature areas LCA. For example, as shown in FIG. 8, the support film SPT may be located in the first high-curvature area HCA1, the first low-curvature area LCA1, and the third low-curvature area LCA3. In some embodiments, the support film SPT may be arranged throughout the entire display area DA.

According to some embodiments of the present invention, the lower surface of the support film SPT may be a flat surface. For example, the lower surface of the support film SPT may be a flat surface. The panel bottom cover PB may not be located directly on the lower surface BS of the first substrate SUB1 but may be located directly on the lower surface of the support film SPT.

In the display device 10 according to some embodiments, the support film SPT is located also on the lower surface BS of the first substrate SUB1, so that the tip at the boundary between the lower surface and the first side surface SS1 of the first substrate SUB1 can also be protected.

In addition, in the display device 10 according to some embodiments, because the lower surface of the support film SPT is a flat surface, the surface quality of the rear surface of the display device 10 can be improved. Accordingly, other members can be more reliably coupled with the rear surface of the display device 10.

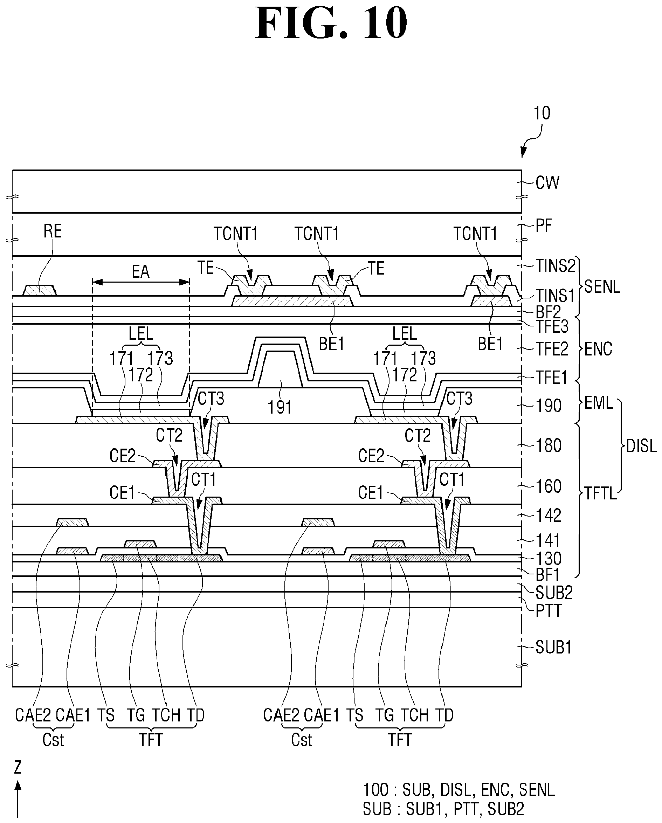

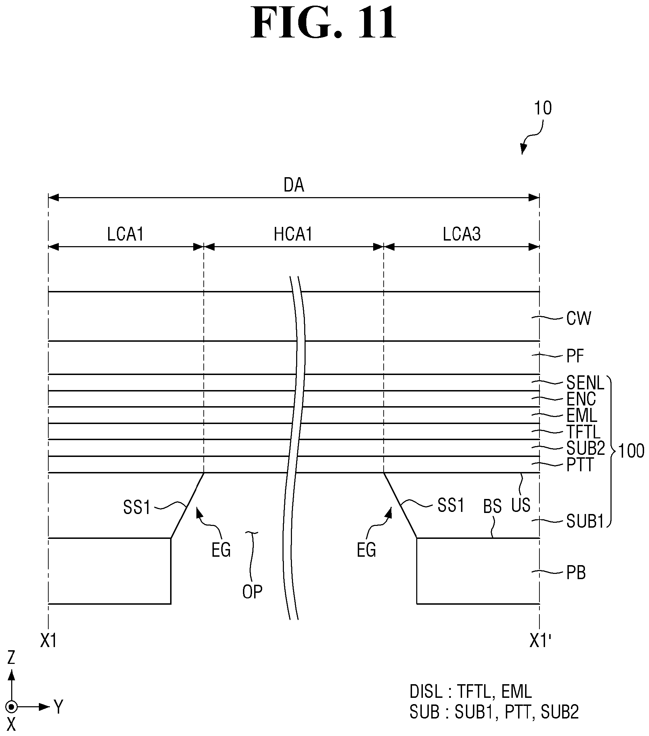

FIGS. 10 and 11 are cross-sectional views showing a display device according to some embodiments of the present invention.

The embodiments of FIGS. 10 and 11 is different from the embodiments of FIGS. 4, 6, 8 and the like in that a display device 10 further includes a protective layer PTT.

For example, the substrate SUB may include a first substrate SUB1, a protective layer PTT located on the first substrate SUB1, and a second substrate SUB2 located on the protective layer PTT.

The first substrate SUB1 may include an opening OP exposing the protective layer PTT. The second substrate SUB2 may be located on the protective layer PTT.

The protective layer PTT may be located between the first substrate SUB1 and the second substrate SUB2. The protective layer PTT may have a thickness of approximately 0.1 µm or less. The protective layer PTT may include a material having higher adhesion to the first substrate SUB1 than to the second substrate SUB2.

In some embodiments, the protective layer PTT may include silicon (Si). For example, the protective layer PTT may include at least one of: amorphous silicon (a-Si), silicon oxide (SiOx), silicon nitride (SiNx), or silicon oxynitride (SiOxNy).

In the display device 10 according to some embodiments, the protective layer PTT can prevent the first substrate SUB1 from being overly etched, thereby preventing an undercut structure. That is to say, it is possible to prevent the first inclined surface IP1_1 (see FIG. 4 or the like) of the display device 10 from being formed according to the above-described embodiments. For example, the adhesive strength of the protective layer PTT to the first substrate SUB1 may be greater than the adhesive strength of the second substrate SUB2 to the first substrate SUB1. In addition, in an etching process of the method S1 of fabricating a display device (see FIG. 13) described below, the reactivity of the protective layer PTT to an etchant may be lower than that of the second substrate SUB2 to the etchant. Accordingly, it is possible to prevent the permeation of the etchant at the interface between the first substrate SUB1 and the protective layer PTT, thereby preventing an undercut from being formed.

As shown in FIG. 11, no undercut is formed between the first high-curvature area HCA1 and the first low-curvature area LCA1 or between the first high-curvature area HCA1 and the third low-curvature area LCA3. Accordingly, it is possible to prevent the edge EG of the first substrate SUB1 that is adjacent to the first high-curvature area HCA1 from being damaged when the display device 10 is bent at the high-curvature areas HCA.

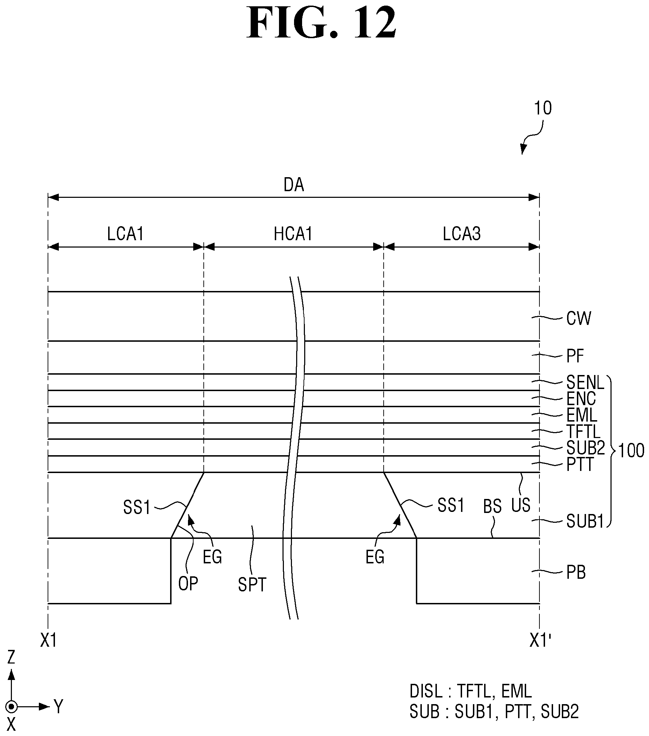

FIG. 12 is a cross-sectional view showing a display device according to some embodiments of the present invention.

The embodiments of FIG. 12 is different from the embodiments of FIG. 11 and the like in that a display device 10 further includes a support film SPT.

For example, the display device 10 according to some embodiments may further include the support film SPT plus the display device 10 according to some embodiments described above with reference to FIG. 11 and the like. The support film SPT may be located in an opening OP of the first substrate SUB1. The support film SPT may be located in the high-curvature areas HCA. For example, as shown in FIG. 12, the support film SPT may be located in the first high-curvature area HCA1.

According to some embodiments of the present invention, the lower surface of the support film SPT may be positioned at the same level as the lower surface BS of the first substrate SUB1. According to some embodiments, as in the display device 10 according to some embodiments described above with reference to FIGS. 8 and 9, the support film SPT may be arranged also on the lower surface BS of the first substrate SUB1 in the display device 10 according to some embodiments.

In the display device 10 according to some embodiments, the first substrate SUB1 can be protected as the support film SPT is located in the opening OP of the first substrate SUB1. For example, edges EG adjacent to the first high-curvature area HCA1 can be protected.

In addition, in the display device 10 according to some embodiments, the lower surface of the support film SPT is positioned at the same level as the lower surface BS of the first substrate SUB1, so that the lower surface BS of the first substrate SUB1 can be flattened. In this manner, the surface quality of the lower surface BS of the first substrate SUB1 can be improved, so that another member can be more reliably coupled to the lower surface BS of the first substrate SUB1.

Hereinafter, a method of fabricating a display device according to some embodiments of the present invention will be described.

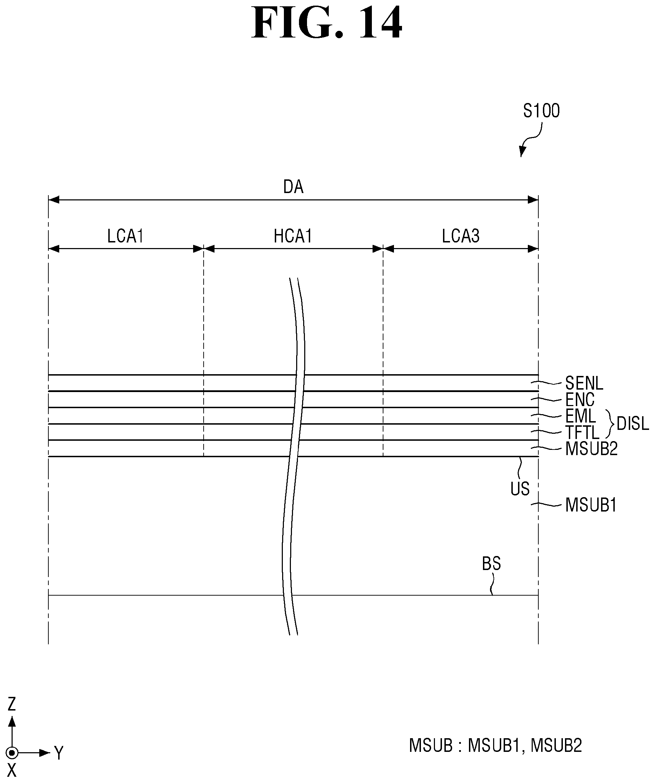

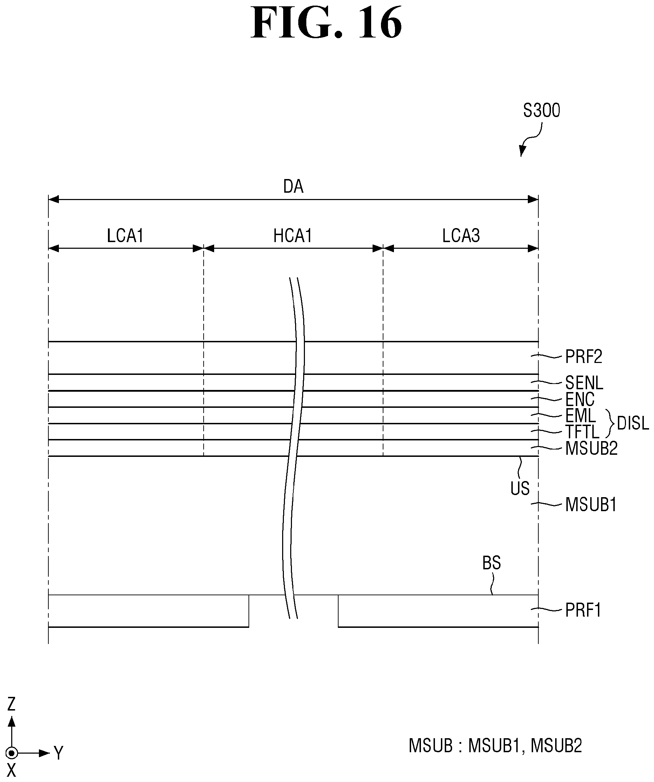

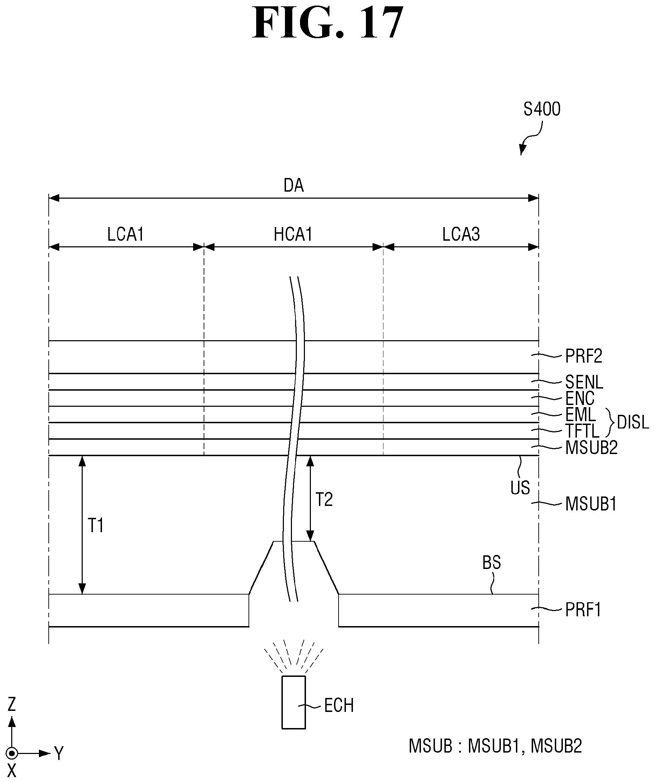

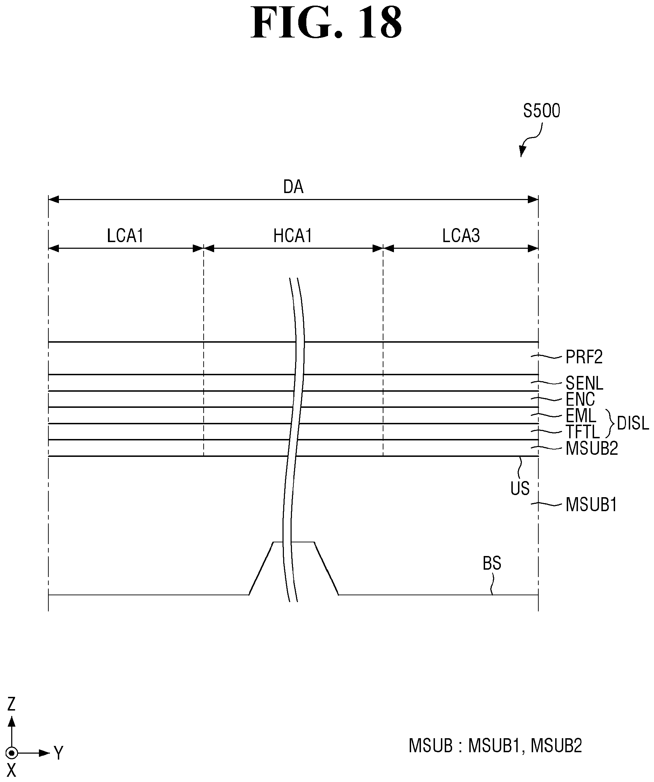

FIG. 13 is a flowchart for illustrating a method of fabricating a display device according to some embodiments of the present invention. FIG. 14 is a cross-sectional view showing step S100 of FIG. 13. FIG. 15 is a cross-sectional view showing step S200 of FIG. 13. FIG. 16 is a cross-sectional view for illustrating step S300 of FIG. 13. FIG. 17 is a cross-sectional view showing step S400 of FIG. 13. FIG. 18 is a cross-sectional view showing step S500 of FIG. 13. FIG. 19 is a cross-sectional view showing step S600 of FIG. 13.

Referring to FIGS. 13 to 19, the method S1 of fabricating a display device according to some embodiments may include, first, forming a second mother substrate MSUB2 and a display layer DISL on an upper surface US of a first mother substrate MSUB1 (step S100 of FIG. 13), as shown in FIG. 14.

For example, a mother substrate MSUB may include the first mother substrate MSUB1 and the second mother substrate MSUB2. The second mother substrate MSUB2 may be formed on the upper surface US of the first mother substrate MSUB1. Subsequently, the display layer DISL may be formed on the second mother substrate MSUB2, and an encapsulation layer ENC and a sensor electrode layer SENL may be further formed.

Second, as shown in FIG. 15, a first protective film PRF1 may be attached on a lower surface BS of the first mother substrate MSUB1, and a second protective film PRF2 may be attached on the display layer DISL (step S200 of FIG. 13).

For example, the first protective film PRF1 may be attached to the entire lower surface BS of the first mother substrate MSUB1. When the encapsulation layer ENC and the sensor electrode layer SENL are located on the display layer DISL, the second protective film PRF2 may be attached on the sensor electrode layer SENL. The second protective film PRF2 may cover the display layer DISL, the encapsulation layer ENC, and the sensor electrode layer SENL altogether.

The first protective film PRF1 and the second protective film PRF2 may be acid-resistant films. The first protective film PRF1 can prevent the first mother substrate MSUB1 from being etched where the first protective film PRF1 is attached. The second protective film PRF2 can protect the display layer DISL from an etchant ECH.

Thirdly, as shown in FIG. 16, a part of the first protective film PRF1 located in the high-curvature areas HCA may be removed (step S300 of FIG. 13).

For example, a part of the first protective film PRF1 located in the first high-curvature area HCA1 may be removed. A part of the lower surface BS of the first mother substrate MSUB1 may be exposed in the first high-curvature area HCA1 from which the first protective film PRF1 is removed.

Fourthly, as shown in FIG. 17, the etchant ECH is sprayed on the lower surface BS of the first mother substrate MSUB1 so that the first mother substrate MSUB1 located in the high-curvature areas HCA may be partially removed (step S400 in FIG. 13).

For example, a part of the first mother substrate MSUB1 located in the first high-curvature area HCA1 may be removed by spraying the etchant ECH onto the lower surface BS of the first mother substrate MSUB1.

As a part of the first mother substrate MSUB1 is removed at the high-curvature areas HCA, there may be differences in thickness of the first mother substrate MSUB1 between the high-curvature areas HCA and the low-curvature areas LCA. For example, the thickness of the first mother substrate MSUB1 in the first high-curvature area HCA1 (second thickness T2) may be smaller than the thickness of the first mother substrate MSUB1 in the first low-curvature area LCA1 and the third low-curvature area LCA3 (first thickness T2). The second thickness T2 may be approximately 0.5 to 0.7 times the first thickness T1.

After the first mother substrate MSUB1 is etched, inclined surfaces may be formed at the high-curvature areas HCA. Such inclined surfaces may be formed by isotropic nature of wet etching.

Fifthly, as shown in FIG. 18, the entirety of the first protective film PRF1 located on the lower surface BS of the first mother substrate MSUB1 may be removed. Accordingly, the entire lower surface BS of the first mother substrate MSUB1 may be exposed (step S500 of FIG. 13).

Sixthly, as shown in FIG. 19, the overall thickness of the first mother substrate MSUB1 may be reduced by spraying the etchant ECH onto the lower surface BS of the first mother substrate MSUB1, and the second mother substrate MSUB2 located on the first mother substrate MSUB1 may be exposed (step S600 of FIG. 13).

By spraying the etchant onto the lower surface BS of the first mother substrate MSUB1, the first thickness T1 of the first mother substrate MSUB1 can be reduced to the third thickness T3. The first thickness T1 may be approximately 500 µm, and the third thickness T3 may be approximately 200 µm, but the present invention is not limited thereto.

Because the first mother substrate MSUB1 is etched without any mask, the entire lower surface BS of the first mother substrate MSUB1 can be etched uniformly (isotropic etch). As a result, the first side surface SS1 may be formed as an inclined surface at the edge EG of the first substrate MSUB1 that is adjacent to the first high-curvature region HCA1 along the inclined surface formed in step S400.

Incidentally, as the thickness of the first mother substrate MSUB1 decreases, a part of the first mother substrate MSUB1 that is located at the first high-curvature area HCA1 may be completely etched, and thus the second mother substrate MSUB2 may be exposed. For example, an opening OP exposing the second mother substrate MSUB2 may be formed. Even after the second mother substrate MSUB2 is exposed, the part of the first mother substrate MSUB1 that is located at the first high-curvature area HCA1 may be overly etched in order to completely remove it. In doing so, the etchant ECH may permeate into the interface between the second mother substrate MSUB2 and the first mother substrate MSUB1. As a result, the first inclined surface IP1_1 may be formed.

In the method S1 of fabricating the display device according to some embodiments, the opening OP of the first substrate SUB1 may overlap the display area DA. That is to say, the high-curvature area HCA may overlap the display area DA in the third direction (z-axis direction). Accordingly, the images can be displayed even in the high-curvature areas HCA at which a part of the display device 10 is bent, so that the aesthetic appeal of the display device 10 can be improved, users can get more immerged into the contents, and a wider display screen can be provided to the users.

In addition, in the method S1 of fabricating a display device according to some embodiments, the display device 10 including the high-curvature areas HCA can have flexibility, and thus can be implemented as a single integrated display in which the plurality of high-curvature areas HCA and the plurality of low-curvature areas LCA are connected with one another despite the steps therebetween. As a result, the aesthetics quality of the display device 10 can be improved, and a more compelling user experience can be provided.

On the other hand, in the method S1 of fabricating a display device according to some embodiments, the surface quality can be improved by including the low-curvature areas LCA. Accordingly, the display device 10 can be more reliably coupled with the electronic device 1 or other components of the electronic device 1.

In concluding the detailed description, those skilled in the art will appreciate that many variations and modifications can be made to the disclosed embodiments without substantially departing from the scope of embodiments according to the present invention. Therefore, the disclosed embodiments of the invention are used in a generic and descriptive sense only and not for purposes of limitation.

## Claims

1. A display device (10) comprising:
a first substrate (SUB1) comprising a first surface and a second surface facing each other and having a rigid material;
a second substrate (SUB2) on the first surface of the first substrate (SUB1) and having a flexible material; and
an emission material layer (EML) on the second substrate (SUB2) and comprising a plurality of light-emitting elements (LEL),
wherein the first substrate (SUB1) further comprises:
an opening (OP) exposing the second substrate (SUB2);
a first side surface (SS1) at an edge (EG) adjacent to the opening (OP) and between the first surface and the second surface;
a first inclined surface (IP1_1) between the first surface and the first side surface (SS1);
a first high-curvature area (HCA1) overlapping the opening (OP); and
a first low-curvature area (LCA1) and a second low-curvature area (LCA2) on one side and an opposite side of the first high-curvature area (HCA1), respectively, and
wherein the first high-curvature area (HCA1) overlaps with the emission material layer (EML).

2. The display device (10) of claim 1, further comprising: an undercut between the first inclined surface (IP1_1) of the first substrate (SUB1) and the second substrate (SUB2).

3. The display device (10) of claim 2, wherein a length of the undercut in a horizontal direction is equal to or less than 120 micrometers.

4. The display device (10) of at least one of claims 1 to 3, wherein an angle between the first inclined surface (IP1_1) and the first surface is less than 15 degrees.

5. The display device (10) of at least one of claims 1 to 4, wherein an angle between the first side surface (SS1) and the second surface is less than 60 degrees.

6. A display device (10) comprising:
a first substrate (SUB1) comprising a first surface, a second surface opposite to the first surface, and a first side surface (SS1) between the first surface and the second surface, and having a rigid material;
a protective layer (PPT) on the first surface of the first substrate (SUB1);
a second substrate (SUB2) on the protective layer (PPT) and having a flexible material; and
an emission material layer (EML) on the second substrate (SUB2) and comprising a plurality of light-emitting elements (LEL),
wherein the first substrate (SUB1) further comprises an opening (OP) exposing the protective layer (PPT),
wherein the first side surface (SS1) is at an edge (EG) adjacent to the opening (OP),
wherein the display device (10) further comprises:
a first high-curvature area (HCA1) overlapping the opening (OP); and
a first low-curvature area (LCA1) and a second low-curvature area (LCA2) on one side and an opposite side of the first high-curvature area (HCA1), respectively, and
wherein the first high-curvature area (HCA1) overlaps with the emission material layer (EML).

7. The display device (10) of claim 6, wherein the first side surface (SS1) is connected directly to the first surface.

8. The display device (10) of at least one of claims 1 to 7, wherein the first substrate (SUB1) is not in the first high-curvature area (HCA1).

9. The display device (10) of at least one of claims 1 to 8, wherein a maximum curvature of the first high-curvature area (HCA1) is greater than maximum curvatures of the first low-curvature area (LCA1) and the second low-curvature area (LCA2).

10. The display device (10) of at least one of claims 1 to 9, wherein a minimum radius of curvature of the first high-curvature area (HCA1) is equal to or less than 10 millimeters or equal to or less than 5 millimeters.

11. The display device (10) of at least one of claims 1 to 10, further comprising: a support film (SPT) in the opening (OP).

12. The display device (10) of claim 11, wherein the support film (SPT) comprises at least one of: a polyurethane resin, a polyimide resin, a polyethylene resin, or a polypropylene resin.

13. The display device (10) of claim 11 or 12, wherein the support film (SPT) overlaps with the first high-curvature area (HCA1).

14. The display device (10) of at least one of claims 1 to 5 and 11 to 13 when not dependent on claim 6, wherein the support film (SPT) is in an undercut between the first inclined surface (IP1_1) and the second substrate (SUB2).

15. The display device (10) of at least one of claims 11 to 14, wherein a surface of the support film (SPT) is on a same plane as the second surface of the first substrate (SUB1).

16. The display device (10) of at least one of claims 11 to 15, wherein the support film (SPT) is on the second surface of the first substrate (SUB1).

17. The display device (10) of at least one of claims 1 to 16, wherein the first substrate (SUB1) is configured to be bent at the first high-curvature area (HCA1).

18. The display device (10) of at least one of claims 1 to 17, wherein the first high-curvature area (HCA1) overlaps with a display area (DA) at which light emitted by the emission material layer (EML) exits.

19. The display device (10) of at least one of claims 1 to 18, wherein the first substrate (SUB1) comprises glass, and the second substrate (SUB2) comprises a polymer resin.

20. An automobile comprising:
a first dashboard (DB1);
a second dashboard (DB2) on one side of the first dashboard (DB1); and
the display device (10) of at least one of claims 1 to 19, on the first dashboard (DB1) and the second dashboard (DB2),
wherein the first low-curvature area (LCA1) is on the first dashboard (DB1); and
the second low-curvature area (LCA2) is on the second dashboard (DB2).

21. The automobile of claim 20, further comprising:
a third dashboard (DB3) between the first dashboard (DB1) and the second dashboard (DB2),
wherein the display device (10) comprises:
a third low-curvature area (LCA3) on the third dashboard (DB3) and between the first high-curvature area (HCA1) and the second low-curvature area (LCA2); and
a second high-curvature area (HCA2) between the second low-curvature area (LCA2) and the third low-curvature area (LCA3), and
wherein the second high-curvature area (HCA2) overlaps with the opening (OP) and the emission material layer (EML).

22. The automobile of claim 21, further comprising:
a center console (CCS) on a lower side of the third dashboard (DB3),
wherein the display device (10) further comprises:
a fourth low-curvature area (LCA4) on the center console (CCS); and
a third high-curvature area (HCA3) between the third low-curvature area (LCA3) and the fourth low-curvature area (LCA4), and
wherein the third high-curvature area (HCA3) overlaps with the opening (OP) and the emission material layer (EML).

23. The automobile of claim 21 or 22, wherein the display device (10) further comprises a fourth high-curvature area (HCA4) at one end of the display device (10), and
wherein the fourth high-curvature area (HCA4) is configured to be bent and coupled to a coupling structure formed in at least one of the first to third dashboards (DB1 to DB3) or the center console (CCS).

24. The automobile of claim 23, wherein the coupling structure is a groove or an opening (OP) concaved into at least one of the first to third dashboards (DB1 to DB3) or the center console (CCS).

25. The automobile of at least one of claims 20 to 24, wherein a step is between the first dashboard (DB1) and the second dashboard (DB2) by a level difference, and
wherein the first high-curvature area (HCA1) overlaps with the step.

26. The automobile of claim 25, wherein the first high-curvature area (HCA1) is configured to be bent along a shape of the step.
